# EUROPÄISCHE PATENTSCHRIFT

(11) **EP 2 494 382 B1**
(45) Veröffentlichungstag und Bekanntmachung des Hinweises auf die Patenterteilung: **11.03.2020**
(21) Anmeldenummer: 10776306.2
(22) Anmeldetag: 25.10.2010
(51) Int. Cl.: G01V 3/08

(54) **VORRICHTUNG UND VERFAHREN ZUR FEHLERFREIEN KAPAZITIVEN MESSWERTERFASSUNG**
APPARATUS AND METHOD FOR CAPACITIVELY RECORDING MEASURED VALUES WITHOUT ERRORS
DISPOSITIF ET PROCÉDÉ PERMETTANT L'ACQUISITION CAPACITIVE SANS ERREUR DE VALEURS DE MESURE

(30) Priorität: 27.10.2009 DE 102009050894; 09.12.2009 DE 102009057439
(43) Veröffentlichungstag der Anmeldung: 05.09.2012
(73) Patentinhaber: Reime, Gerd, 77815 Bühl (DE)
(72) Erfinder: Reime, Gerd, 77815 Bühl (DE)
(74) Vertreter: Reinhardt, Harry
(86) Internationale Anmeldenummer: PCT/EP2010/006507
(87) Internationale Veröffentlichungsnummer: WO 2011/054459

(56) Entgegenhaltungen:
- WO-A1-2005/109040
- DE-A1- 10 239 431
- DE-C1- 10 131 243
- US-A- 5 726 581

## Beschreibung

Die Erfindung betrifft eine Vorrichtung und ein Verfahren zur fehlerfreien kapazitiven Erfassung von Objekten hinter einem für elektromagnetische Strahlung durchlässigen flächigen Gegenstand, beispielsweise einer Platte, nach dem Oberbegriff der Ansprüche 1 bzw. 6.

Sensoren, die durch einen flächigen Gegenstand, beispielsweise durch eine Platte, der nicht für optische Strahlung durchlässig ist, die Anwesenheit oder Bewegung eines nicht metallischen Objektes erfassen, sind meist nach dem Prinzip der Kapazitätsmessung aufgebaut. Eine bekannte Anwendung sind z.B. kapazitive Touchpads wie z.B. aus der DE 103 24 579 A1 bekannt, kapazitive Annäherungssensoren (DE 101 31 243 C1), oder der sogenannte "Stud-Detector" (Balkenfinder). So ist in der DE 101 31 243 C1 ein Sensor mit Sensorelektroden und eine zugeordnete Steuerschaltung zur Auswertung der Sensorsignale vorgesehen, wobei eine weitere Elektrode die Sensorelektrode umgibt.

Bei den beiden erstgenannten Anwendungen ist die Sensoreinheit fest mit der zu durchdringenden Platte verbunden und, von der Sensoreinheit aus gesehen, bewegt sich das zu erfassende Objekt hinter dieser Platte. Der Sensor und die Platte haben durch die mechanische Anordnung eine feste Kapazität zueinander, die sich im Messwert als konstante Grundkapazität widerspiegelt.

Eine weitere Anwendung sind Sensoren, die über dem flächigen Gegenstand bzw. der Platte bewegt werden müssen, um dahinter liegende Objekte zu orten, wie dies z.B. aus der EP 0 657 032 B1 und der EP 1 740 981 B1 bekannt ist. Dazu gehören die sogenannten "Balkenfinder" (Stud-Detector). Balkenfinder sind allgemeine Hilfsgeräte für Heimwerker und Profis, um z.B. in Fertighäusern hinter einer geschlossenen Holzverschalung oder Beplankung Balken, Pfosten oder Rohr- bzw. Stromleitungen zu detektieren. Dazu wird der Sensor über die Wand geführt. Er misst mittels einer Elektrode die Kapazität zur Wand. Befindet sich ein Holzbalken, eine Rohr- oder Stromleitung im Erfassungsbereich, erhöht sich durch die Veränderung des Dielektrikums die Kapazität. Diese wird entsprechend ausgewertet und dem Anwender zur Anzeige gebracht. So lange der Sensor mit exakt gleichem Abstand zum flächigen Gegenstand oder zur Platte bewegt wird, verändert sich die Kapazität zwischen Sensor und dem flächigen Gegenstand oder der Platte nicht. Sie geht wie bei den ersten beiden Beispielen nur als konstanter Wert in das Messsignal ein. Am Beispiel des Balkenfinders kann man jedoch nachvollziehen, dass das Einhalten eines konstanten Abstands in der Praxis nahezu unmöglich ist und sich daher die durch den Wandaufbau bedingte Grundkapazität in Abhängigkeit des Abstands erheblich ändert. Daher wird in der nachfolgenden Beschreibung der Erfindung auch der Balkenfinder als Ausführungsbeispiel gewählt.

Im Allgemeinen ist die Grundkapazität, die durch den Wandaufbau gebildet wird, wesentlich höher als die Kapazitätszunahme durch ein hinter der Wand liegendes Objekt. Wird der Balkenfinder über die Wand bewegt, können schon geringste Verkippungen, hervorgerufen durch Wandunebenheiten, eine starke Kapazitätsabnahme bewirken, so dass das zu erfassende Objekt nicht mehr erkannt werden kann. Besonders stark macht sich dieser Effekt bei Strukturputz, Raufasertapeten oder Übergängen zwischen Tapetenschichten bemerkbar. Der Strukturputz führt nicht nur zu Verkippung des Sensors, er ist in der Regel auch ungleichmäßig aufgetragen. Da die Stärke einer solchen Putzschicht auch auf das Messergebnis des Sensors einen starken Einfluss hat, wird die Suche nach dem Balken oder Pfosten reine Glückssache. Des Weiteren gehen in die Grundkapazität auch lokale Inhomogenitäten des Wandaufbaus ein, besonders wenn sie sich oberflächennah, also in Sensornähe befinden.

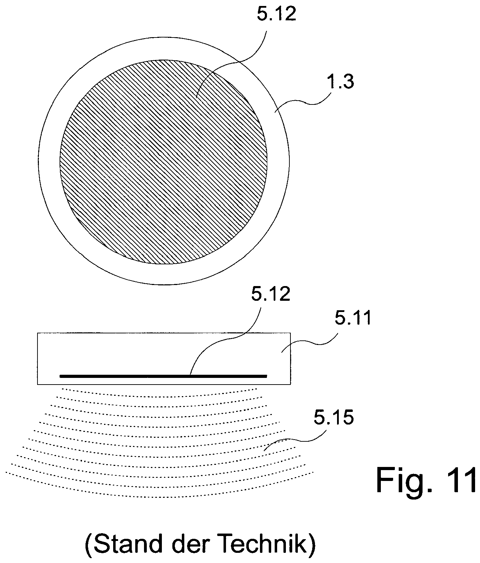

Zur besseren Erläuterung sei hier der Effekt des Verkippens bei einem herkömmlichen Sensor nach dem Stand der Technik dargestellt. Fig. 11 zeigt einen Sensor 1.3 mit einer Elektrode 5.12 zur Bestimmung der Kapazität mittels eines elektromagnetischen Feldes 5.15. Die dazugehörige Elektronik ist nicht dargestellt, die Funktionsweise wird als bekannt vorausgesetzt.

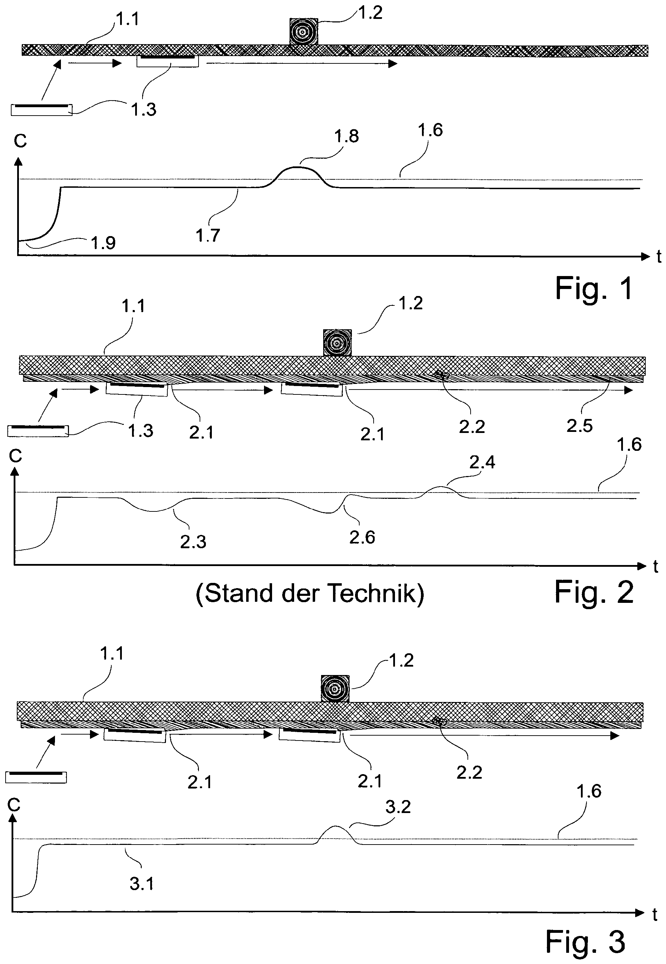

Wird gemäß Fig. 1 der Sensor 1.3 aus einer vorgegebenen Position auf eine Wand 1.1 zu bewegt, verändert sich der Kapazitätswert C, dargestellt in der Messkurve 1.7 hin zu höheren Werten, bis die nächstmögliche Annäherung an die Wand 1.1 hergestellt ist. Eine ideale Bewegung entlang der Wand verändert den Messwert nicht, so lange kein Pfosten, Balken 1.2 oder ähnliches hinter der Wand liegt. Zur Anzeige eines Balkens o.ä. kann dann z.B. ein Schwellwert 1.6 so oberhalb des Messwertes 1.7 gelegt werden, dass dieser bei einem Überfahren des Balkens 1.2 durch die entstehende Messwerterhöhung 1.8. überschritten wird.

Fig. 2 zeigt eine Messkurve, wie sie jedoch oft in der Realität vorkommt. Dargestellt ist die Wand 1.1 mit einer Putzbeschichtung 2.5, Unregelmäßigkeiten 2.1 und Inhomogenitäten 2.2. Die Unregelmäßigkeit kann z.B. eine etwas dickere Stelle im Putz sein oder ein Tapetenstoß. Trifft der Sensor 1.3 auf die Unregelmäßigkeit 2.1, hebt seine Sensorfläche zwangsweise leicht von der Wand ab. Dadurch verringert sich die Kapazität, die Messkurve 1.7 nimmt entsprechend ab (Fig. 2, 2.3). Da dabei der Schwellwert 1.6 nicht überschritten wird, ist dies zunächst kein Problem.

Kritisch wird es, wenn diese Unregelmäßigkeit im Bereich des zu ortenden Balkens 1.2 liegt. Dann kann es dazu kommen, das der Balken nicht erkannt wird (Fig. 2, 2.6). Das heißt, die Kapazitätszunahme durch den hinter der Wand liegenden Balken wird durch das Verkippen des Sensors auf der Unregelmäßigkeit 2.1 überdeckt. In diesem Fall wird der Schwellwert 1.6 nicht überschritten und der Balken daher nicht geortet. Anders ist es bei einer Inhomogenität, z.B. einem Nagel. Dabei erhöht sich möglicherweise der Messwert 1.7 so weit, das der Schwellwert 1.6 überschritten und ein "Balken" vorgetäuscht wird.

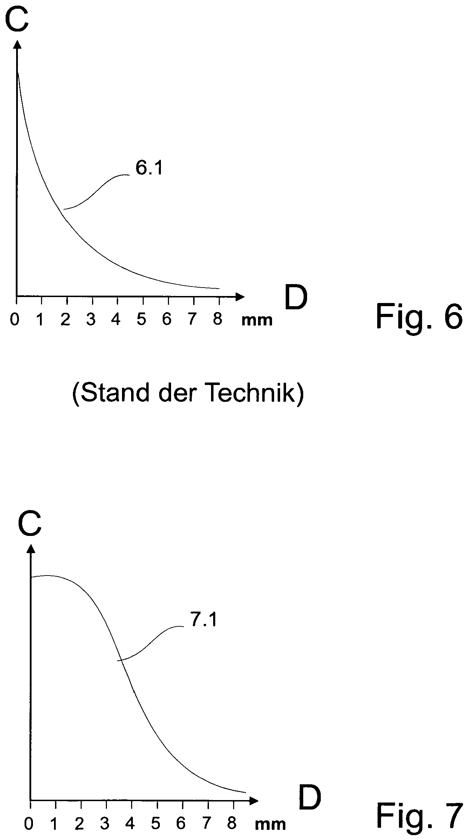

Die detektierte Kapazitätsabnahme des Sensors bei Verkippen bzw. leichten Abheben von der Wand nach dem Stand der Technik ist in Fig. 6 dargestellt. Es ist deutlich zu erkennen, dass im Stand der Technik in den ersten Millimetern einer Verkippung oder Entfernung des Sensors von der Oberfläche (Fig. 6, D) die stärkste Änderung in der Kapazitätskurve 6.1 auftritt.

Aus der DE 10 2005 031 607 A1 ist eine Vorrichtung zur Wandlung der kapazitiven Signaländerung eines Differential-Kondensators, welcher in Beschleunigungssensoren verwendet wird, in ein digitales Signal bekannt. Hierzu wird ein Sigma-Delta-Modulator verwendet. Das Prinzip der Sigma-Delta-Modulation beruht auf einer groben Messung eines Signals mittels eines Quantisierers. Der dabei entstehende Messfehler wird integriert und über eine Gegenkopplung fortwährend kompensiert. Je nachdem, welche Art von Umwandlung vorgenommen werden soll, sind die einzelnen Blöcke des Sigma-Delta-Modulators digital oder analog ausgeführt. Der Differential-Kondensator ist in den Gegenkopplungspfad und die Referenzrückkopplungsstruktur integriert. Dadurch kann eine Kapazitätsänderung direkt von einem analogen Wert in ein digitales Signal gewandelt werden. Durch die Einbindung des Differential-Kondensators wird das Ausgangssignal des Wandlers in Form eines Binärstroms in erster Nährung nur abhängig von der Auslenkung der seismischen Masse des Differential-Kondensators. An die Elektroden des Differential-Kondensators werden verschiedene Referenzspannungen angelegt, die in einem bestimmten zeitlichen Muster mit bestimmter Amplitude wählbar sind. Durch verschieden gewählte Referenzspannungen können verschiedene Wertebereiche und Auflösungen des zu digitalisierenden Signals dargestellt werden. Durch eine geeignet gewählte Abfolge der Referenzspannungen wird ein Polaritätswechsel des Eingangssignals realisiert. Zudem kann für eine Selbsttestfunktion über die Folge der Referenzspannungen und eines geeigneten Taktschemas zum Aufschalten der Referenzspannungen auf die Elektroden eine Stellkraft auf die bewegliche Elektrode ausgeübt werden. Durch die Wahl der Referenzspannungen wird im zeitlichen Mittel eine Potentialgleichheit der Elektroden erreicht. Hierdurch wird eine elektrische Aufladung der seismischen Masse und die daraus entstehende Änderung des Ausgangssignals verhindert. Es erfolgt jedoch keine gegenläufige Regelung einer Sensorelektrode und einer die Sensorelektrode umgebenden weiteren Elektrode.

Die DE 198 43 749 A1 zeigt als kapazitiver Näherungsschalter ein Verfahren und eine Schaltungsanordnung zur Auswertung kleiner Kapazitätsänderungen. Hierzu wird eine Brückenschaltung verwendet, in deren Brückenzweigen sich als Blindwiderstände je ein Kondensator befindet. Die beiden Brückenzweigspannungen werden getrennt nach dem jeweiligen Brückenzweig gleichgerichtet, wonach die Brückendiagonalspannung als sich entsprechend der Kapazitätsänderung der Kapazität ändernde Gleichspannung ausgewertet wird. Der Näherungsschalter besteht aus einer Mehrlagenplatine mit zwei elektrisch isolierenden Schichten, zwischen denen sich eine metallische Zwischenlage als erste Fläche eines Kondensators befindet. Auf einer der beiden Schichten ist eine flächige Auflage als Sonde aufgebracht, welche die zweite Fläche des Kondensators bildet. Eine Metallfläche ist relativ zur Sonde beweglich angeordnet und bildet mit dieser einen zweiten veränderbaren Kondensator. Durch diese Schaltungsanordnung wird eine erhöhte Störfestigkeit sowie eine erhöhte Temperaturstabilität erreicht. Hierzu wird die Schaltung mittels eines Drehkondensators derart abgeglichen, dass im Schaltzeitpunkt des Näherungsschalter die Differenzspannung gleich Null ist, da es dann ausreicht, lediglich das Vorzeichen auszuwerten.

In der US 7,148,704 B2 ist eine kapazitive Erfassung der Position eines Objekts gezeigt, nämlich eines Fingers auf einem Touchpad. Der hierzu verwendete Sensor umfasst zwei Messkanäle, welche jeweils mit einer Elektrode verbunden sind. Die Kanäle werden synchron betrieben, wobei jeder Kanal eine nicht-lineare Antwort auf einen kapazitiven Einfluss des Fingers gibt. Diese jeweiligen Ausgangssignale werden linear zusammengefasst, um Positionssignale zu liefern, die sich linear mit der Position des Fingers verändern, weshalb der Sensor als ratiometrischer Sensor arbeitet.

Die US 5,585,733 zeigt eine Vorrichtung und ein Verfahren zur Messung der Änderung der Kapazität eines kapazitiven Sensors. Hierzu sind Mittel zur Aufbringung eines konstanten elektrischen Stroms an einer Elektrode und Mittel zur Erzeugung einer ersten Reihe von Taktpulsen vorgesehen. Die Spannung des Kondensators wird mit einer Referenzspannung verglichen, wobei ein Signal erzeugt wird, wenn die Spannung des Kondensators die Referenzspannung überschreitet. Der kapazitive Sensor wird zur Messung der Änderung einer Dimension eines in den Dimensionen veränderlichen Gegenstands verwendet, wie beispielsweise einer Teleskopeinrichtung. Der Kondensator wird durch zwei elektrisch leitfähige Schichten gebildet, die dielektrische Hülsen eines Kolbens umschließen. Durch die Bewegung des Kolbens und damit der Hülsen wird die Kapazität des Kondensators verändert. Diese Änderung wird durch die Steuerung erfasst und ausgewertet, wodurch die Änderung der Position des Kolbens erfasst wird.

Die DE 39 42 159 A1 zeigt eine Schaltungsanordnung zur Verarbeitung von Sensorsignalen, die mittels eines kapazitiven Sensors erfasst werden. Der Sensor umfasst eine durch die zu erfassenden physische Messgröße beeinflussbare Messkapazität und einen Referenzkondensator, der eine Referenzkapazität aufweist und einen von der Messkapazität und der Referenzkapazität abhängigen Messeffekt liefert. Erste Elektroden der Kondensatoren des Sensors liegen auf einem festen Potential, während zweite Elektroden zur Durchführung des Ladungstransports mit einem ersten Eingang eines Eingangsoperationsverstärkers verbunden sind, dessen zweiter Eingang auf einem Bezugspotential liegt. Die zur Bildung der transportierten Ladung erforderliche Umladung der Kondensatoren des Sensors erfolgt durch die Umschaltung des Bezugspotentials des Eingangsoperationsverstärkers. Somit liegen beide Eingänge des Operationsverstärkers im Wesentlichen virtuell auf dem gleichen Potential. Bedingt durch die Umschaltung des Bezugspotentials des Eingangsoperationsverstärkers wird daher auch das Potential der jeweils mit dem anderen Eingang verbundenen Kondensatorelektrode in gleicher Weise geändert. Somit werden die erforderlichen Spannungsänderungen an den mit der Signalleitung verbundenen Kondensatorelektroden vorgenommen, so dass nur diese aktiv sind. Die anderen Elektroden sind dann inaktiv und liegen auf einem beliebigen Potential, zum Beispiel auf dem Gehäusepotential des Sensors.

Aufgabe der Erfindung ist die Schaffung eines kapazitiven Sensors, der vermindert und im besten Falle nicht auf Verkippung zur Oberfläche oder kleine Abstandsänderungen zur Oberfläche reagiert.

Diese Aufgabe wird durch eine Vorrichtung mit den Merkmalen des Anspruches 1 und ein Verfahren mit den Merkmalen des Anspruches 6 gelöst.

Damit entsteht ein Sensor, der auch einen variablen Abstand zum flächigen Gegenstand beispielsweise einer Platte einnehmen kann. Gleichzeitig unterdrückt die umgebende Elektrode elektrische Einflüsse wie z.B. durch Feuchtigkeitsfilme auf der Sensoroberfläche. Am Ausführungsbeispiel eines "Balkenfinder" ergibt sich damit ein Sensor, der nicht auf Verkippung durch Wandunebenheiten, leichtes Abheben, unterschiedliche Stärke einer Putzschicht oder lokale Inhomogenitäten reagiert. Gleichzeitig ergibt sich eine gegenläufige Regelung einer Sensorelektrode und einer die Sensorelektrode umgebenden weiteren Elektrode.

Zudem können die Signale vorzugsweise so stark verstärkt werden, dass eine deutlich höhere Reichweite z.B. hinter dem überstrichenen flächigen Gegenstand möglich wird oder sich die Objekte deutlicher abzeichnen. Findet dabei eine Messwertverrechnung aus mehreren Sensorelektroden zur Positionsdarstellung und/oder Dickendarstellung des Objekts statt, kann dieses auf einem Display dargestellt werden. Dies betrifft genauso die Darstellung einer Inhomogenität, z.B. einer Schraube als Einzelobjekt auf dem Display.

Im Anwendungsfall der Touchpads und Annäherungssensoren kann ein kapazitiver Sensor in kleiner Ausführung realisiert werden, der die Position eines Fingers erfasst, bei der der Finger von einem festen Auflagepunkt aus nur gekippt, bzw. leicht aus der Position heraus "gerollt" wird. Die detektierte Position kann dann z.B. für eine Cursorsteuerung verwendet werden. Um eine fühlbare Haptik zu erreichen, wird zum Auslösen einer Funktion die Oberfläche gedrückt, z.B. um einen mechanische Microschalter zu betätigen. Ist aus konstruktiven Gründen der kapazitive Sensor nicht im beweglichen Teil integriert, wird trotz der Bewegung der Oberfläche während des Druckvorgangs die detektierte Position nicht "verrissen".

Bei den Touchpads kann statt dem "Balken" auf dem Display eine Mausfunktion in Folge der Verrechnung der Messkurven mehrere Sensorteilbereiche dargestellt werden. Zudem ist auf Grund der hohen Empfindlichkeit des Systems auch eine Abstandserfassung eines sich annähernden Objekts wie eines Fingers in Richtung der Z-Achse möglich.

Vorzugsweise wird bei einem "stud finder" nicht nur die Anwesenheit sondern auch die Lage eines Balkens hinter der Wand dargestellt.

Weitere Vorteile ergeben sich aus den Unteransprüchen und der nachfolgenden Beschreibung.

Im Folgenden wird die Erfindung an Hand von in den beigefügten Figuren dargestellten Ausführungsbeispielen erläutert. Es zeigen:
- Fig. 1: eine ideale Bewegung eines Sensors entlang eines flächigen Gegenstands sowie die dabei auftretende Änderung des Kapazitätswerts C,
- Fig. 2: eine Bewegung eines Sensors nach dem Stand der Technik entlang des flächigen Gegenstands gemäß Fig. 1 sowie die dabei auftretende Änderung des Kapazitätswerts C,
- Fig. 3: eine Bewegung eines erfindungsgemäßen Sensors entlang des flächigen Gegenstands gemäß Fig. 1 sowie die dabei auftretende Änderung des Kapazitätswerts C,
- Fig. 4: ein Ausführungsbeispiel einer Sensorelektronik mit einer geschlossenen Regelung zur konstanten Erhaltung der Signalamplitude an der Sensorelektrode,
- Fig. 4.1: ein weiteres Ausführungsbeispiel einer Sensorelektronik mit Impedanzwandlern,
- Fig. 5: einen erfindungsgemäßen Sensor,
- Fig. 6, 7: die Abnahme der Kapazität bei zunehmendem Abstand von dem flächigen Gegenstand bei einem Sensor nach dem Stand der Technik und bei einem erfindungsgemäßen Sensor,
- Fig. 8, 9: ein Ausführungsbeispiel eines weiteren erfindungsgemäßen Sensors mit Messwertverläufen verschiedener Kapazitätsverhältnisse und einer Anzeigeeinheit bei einem senkrecht und bei einem diagonal liegenden Balken oder Pfosten,
- Fig. 10: ein Ausführungsbeispiel einer äußeren Beschaltung zur Realisierung der Erfindung mit einem IC,
- Fig. 11: einen Sensor mit einer Elektrode zur Bestimmung der Kapazität nach dem Stand der Technik.

Die Erfindung wird jetzt beispielhaft unter bezug auf die beigefügten Zeichnungen näher erläutert. Allerdings handelt es sich bei den Ausführungsbeispielen nur um Beispiele, die nicht das erfinderische Konzept auf eine bestimmte Anordnung beschränken sollen. Bevor die Erfindung im Detail beschrieben wird, ist darauf hinzuweisen, dass sie nicht auf die jeweiligen Bauteile der Vorrichtung sowie die jeweiligen Verfahrensschritte beschränkt ist, da diese Bauteile und Verfahren variieren können. Die hier verwendeten Begriffe sind lediglich dafür bestimmt, besondere Ausführungsformen zu beschreiben und werden nicht einschränkend verwendet. Wenn zudem in der Beschreibung oder in den Ansprüchen die Einzahl oder unbestimmte Artikel verwendet werden, bezieht sich dies auch auf die Mehrzahl dieser Elemente, solange nicht der Gesamtzusammenhang eindeutig etwas Anderes deutlich macht.

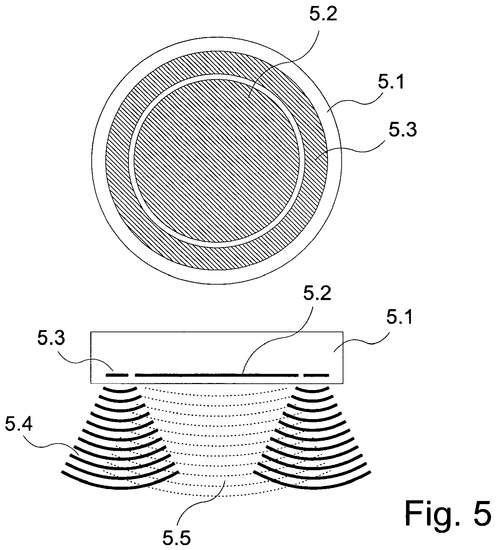

Gegenüber dem Stand der Technik werden im erfindungsgemäßen Sensor 5.1 zur Detektion wenigstens zwei Elektroden eingesetzt. Fig. 5 zeigt eine mögliche Anordnung. Eine ringförmige Elektrode 5.3 umgibt dabei die Sensorelektrode 5.2.

Hierbei handelt es sich aber nicht um die im Stand der Technik so oft verwendete Schirmelektrode, die den inhomogenen Randbereich des elektrischen Felds eines kapazitiven Sensors von der Messelektrode abschirmt und so ein homogenes Feld bis an den Rand der Sensorfläche gewährleistet. Diese wird ja abhängig von dem Potential an der Messelektrode auf gleichem Potential mitgeführt. Dadurch wird die parasitäre Kapazität gegenüber einer umgebenden Massefläche eliminiert. Diese Maßnahme bevorzugt man, wenn nur kleine Kapazitätsänderungen an der Messelektrode detektiert werden sollen. Würde diese Messanordnung zur Balkenortung eingesetzt, ergibt sich beim Verkippen des Sensors in etwa die gleiche Kurve wie in Fig. 6 dargestellt.

Nimmt im Stand der Technik das Potential an der Messelektrode zu oder ab, folgt die Schirmelektrode also diesem Potential. Als "Potential" kann eine Sinus- oder Recheckwechselspannung hochohmig auf die Messelektrode gegeben werden, eine Kapazitätserhöhung an der Messelektrode führt zu einer Verformung oder bei entsprechender Frequenz zu einer Abnahme der Wechselspannung.

"Hochohmige" Ankopplung heißt in der weiteren Darstellung, dass eine Kapazitätsänderung, z.B. durch einen Balken hinter der Wand, zu einer auswertbaren Änderung des Signals an der Messelektrode führt. "Niederohmige" Ankopplung heißt demnach, das z.B. die regelmäßig große Kapazitätsänderung durch Annähern des Sensors an die Wand nicht zu einer wesentlichen Beeinflussung des Kurvenverlaufs der Wechselspannung führt.

Eine "hochohmige" Ankoppelung der Messelektrode an die sendende Elektronik kann z.B. durch einen 470KOhm Widerstand (bei einer Frequenz von z.B. 100 kHz) erfolgen. Dabei sind auch kleine Kapazitätsänderungen an der Messelektrode deutlich im Kurvenverlauf zu erkennen. Eine "niederohmige" Ankoppelung liegt z.B. bei Widerstandswerten um 100 Ohm vor, eine kleine Kapazitätsänderung an der angeschlossenen Elektrode führt dann zu einer kaum messbaren Signalbeeinflussung.

Im erfindungsgemäßen Verfahren wird gemäß Fig. 5 die umgebende Elektrode 5.3 jedoch nicht auf dem Potential der Sensorelektrode 5.2 bzw. Messelektrode nachgeführt. Es wird vielmehr die Sensorelektrode ständig auf festgelegtem konstanten Potential gehalten. Bei Potentialabnahme durch eine Kapazitätserhöhung an der Sensorelektrode 5.2 wird das Potential der umgebenden Elektrode 5.3 so nachgeregelt, bis an der Sensorelektrode 5.2 wieder das festgelegte konstante Potential erreicht wird. Der Wert der Nachregelung ist dann der Wert der Kapazitätsänderung an der Sensorelektrode.

Im nachfolgenden Ausführungsbeispiel wird eine Rechteck-Wechselspannung mit einer Frequenz von 100 kHz angelegt. Bei entsprechend hochohmiger Ankopplung verändert sich die Amplitude an der Sensorelektrode 5.2 bei Veränderung der Kapazität. Eine Amplitudenänderung bei Annäherung an einer Wand beträgt dann z. B. 10 %, ein zusätzlicher Balken 1.2 hinter der Wand verändert die Amplitude zusätzlich z.B. um 0.1%. Diese Werte entsprechen der Praxis bei einer Holzwand von 18mm Stärke und einem Balken von 5x5 cm, können jedoch bei unterschiedlichem Wandaufbau und div. Objekten dahinter stark unterschiedlich ausfallen.

Wenn im Folgenden von Signalamplituden an den Elektroden die Rede ist, bezieht sich dieser Ausdruck auf oben genannte Darstellung.

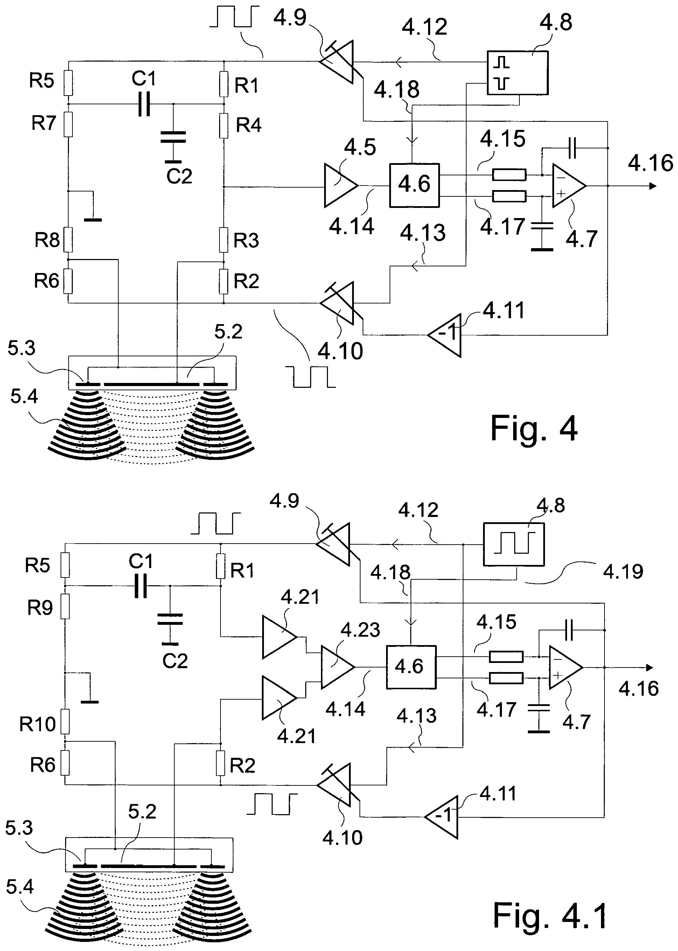

Fig. 4 zeigt ein Ausführungsbeispiel einer Sensorelektronik mit einer geschlossenen Regelung zur konstanten Erhaltung der Signalamplitude an der Sensorelektrode. Ein Taktgenerator 4.8 liefert ein erstes Taktsignal 4.13 mit einer Frequenz von z.B.100 kHz an eine erste geregelte Spannungsquelle 4.10 und ein zweites invertiertes Taktsignal 4.12 an eine zweite geregelte Spannungsquelle 4.9. Die erste geregelte Spannungsquelle 4.10 speist den niederohmigen Spannungsteiler aus R6 und R8, an dessen Mittelpunkt die Elektrode 5.3 liegt.

Parallel dazu speist die gleiche Spannungsquelle 4.10 den hochohmigen Spannungsteiler R2 und R3. Der Fußpunkt von R3 liegt am Eingang des Wechselspannungsverstärkers 4.5. Da das Eingangssignal dieses Verstärkers aufgrund der im Folgenden näher erläuterten Regelung ständig auf "0" gehalten wird, kann hier für den Spannungsteiler R2 / R3 von einem virtuellen Massepotential ausgegangen werden. Am Mittelpunkt des Spannungsteilers R2 und R3 ist die Sensorelektrode 5.2 angeschlossen.

Das Verhältnis von R2 zu R3 entspricht vorzugsweise dem Verhältnis von R6 zu R8. In der Praxis z.B. je 100 Ohm für R6 und R8 und je 470KOhm für R2 und R3.

Analog zu dieser Anordnung speist die zweite geregelte Spannungsquelle 4.9 den niederohmigen Spannungsteiler R5 und R7 und den hochohmigen Spannungsteiler R1 und R4. Die Sensorelektrode 5.2 bildet eine Kapazität gegenüber der Umwelt, z.B. gegenüber dem Gehäuse des Sensors. Die Kapazität des Kondensators C2 wird in etwa so groß wie diese Kapazität gewählt. Auch besteht zwischen der Sensorelektrode 5.2 und der umgebenden Elektrode 5.3 eine Kapazität. Die Kapazität des Kondensators C1 wird in etwa so groß wie diese Kapazität gewählt. C2 bildet somit die feststehende Referenzkapazität für die Sensorelektrode 5.2. Die Werte von R5, R7, R1 und R4 entsprechen den Werten für R6, R8, R2 und R3. Dieser Schaltungsteil bildet damit insgesamt eine Referenzstrecke zur den Sensor 5.1, 8.1 umfassenden Sendestrecke aus.

Die Messwertverrechnung aus mehreren Sensorelektroden bzw. Sensorteilbereichen SA, SB, SC, SD kann somit zur Positionsdarstellung und/oder Dickendarstellung des Objekts hinter einer Wand auf einem Display oder auch zur Darstellung einer Inhomogenität wie einer Schraube als Einzelobjekt auf dem Display genutzt werden. In den anderen Anwendungsbereichen der Erfindung ist auch eine Mausfunktion auf dem Display vorstellbar. Statt dem "Balken" wird dann die Mausfunktion auf dem Display dargestellt, wobei die Verrechnung der Messkurven in gleicher Weise erfolgen kann.

Bei gleicher Spannung an den Ausgängen der Spannungsquellen 4.10 und 4.9 hebt sich das Eingangssignal am Wechselspannungsverstärker 4.5 auf.

Da der Verstärker 4.5 am Eingang im ausgeregeltem Zustand der Schaltung lediglich Rauschen sieht, kann er sehr hoch verstärken, bzw. als hoch verstärkender Begrenzerverstärker ausgeführt werden. Das Ausgangssignal des Verstärkers 4.5 wird dem Synchrondemodulator 4.6 zugeführt. Dieser erhält sein zur Demodulation nötiges Taktsignal über 4.18 aus dem Taktgenerator 4.8. Im einfachsten Fall führt der Synchrondemodulator 4.6 das Ausgangssignal des Verstärkers 4.5 während des gesamten Abschnitts einer Taktphase synchron den entsprechenden Eingängen des integrierenden Komparators 4.7 zu. Es ist jedoch auch möglich, nur taktabschnittsweise zu demodulieren.

Bei gleicher Spannung des ersten Eingangssignals 4.15 und zweiten Eingangssignals 4.17 des integrierenden Komparators 4.7 entsteht somit kein taktsynchroner Signalanteil am Eingang des Wechselspannungsverstärkers 4.5.

Die den beiden Taktsignalen 4.12 und 4.13 zuordenbaren Ausgangssignale des Synchrondemodulators 4.6 werden vom integrierenden Komparator 4.7 auf Amplitudenunterschiede untersucht. Der Komparator 4.7 kann als hochverstärkende Vergleicherschaltung ausgeführt sein. Jede noch so kleine Abweichung der Eingangsspannungen 4.15 und 4.17 führt zu einer entsprechenden Abweichung des Regelwertes 4.16 vom momentanen Wert. Auf Grund der hohen Empfindlichkeit des Systems, d.h. auf Grund der hohen Verstärkung ist auch eine Annäherungsfunktion an den Sensor in Richtung einer Z-Achse möglich. Die zugehörige Information kann aus der Amplitude der Messkurven entnommen werden. So ist z.B. bei einer Mausfunktion eine Fingerdetektion z.B. bis 50 mm möglich.

Die geregelten Spannungsquellen 4.9 und 4.10 werden mittels Invertierstufe 4.11 gegeneinander mit dem Regelwert 4.16 invertiert angesteuert. Steigt die Spannung einer der geregelten Spannungsquellen, so fällt sie in der anderen entsprechend ab. Für die Funktion des erfindungsgemäßen Sensors müssen jedoch nicht unbedingt die Spannungsquellen 4.9 bzw. 4.10 beide gegeneinander geregelt werden, es reicht auch die Regelung einer Spannungsquelle aus. Der Regelkreis wird über die Spannungsteiler, gebildet aus R1, R4 und R2, R3, geschlossen. Die Strecke über R1 und R4 bildet dementsprechend die Referenz zur Strecke über R3 und R2.

Ohne den Einfluss eines flächigen Gegenstands der die Kapazität des Sensors verändert, z.B. der Wand, stellt sich daher ein Gleichgewicht der Spannungen am Ausgang der geregelten Spannungsquellen 4.9 und 4.10 in der Art ein, so das am Eingang des Verstärkers 4.5 keine taktsynchronen Anteile entstehen, das heißt, dass lediglich ein Rauschsignal am Eingang des Verstärkers 4.5 anliegt. Der Regelausgang 4.16 wird somit einen bestimmten elektrischen Wert einnehmen, der einem bestimmten, konstruktiv bedingten Kapazitätswert der Sensorelektrode 5.2 entspricht.

Wenn nun z.B. der Sensor auf die Wand aufgesetzt wird, ändert sich die Kapazität der beiden Elektroden 5.2 und 5.3. Vorzugsweise ist dabei die aktiv auf die Oberfläche eines Objektes einwirkende Fläche der umgebenden Elektrode 5.3 etwa gleich groß der Fläche der Sensorelektrode 5.2. Die Kapazitätsänderung an der umgebenden Elektrode 5.3 wirkt sich so gut wie nicht auf den Regelkreis aus. Anders sieht es bei der Sensorelektrode 5.2 aus. Die Spannung wird aufgrund der Hochohmigkeit von R2, R3 abnehmen wollen. In diesem Fall entsteht am Eingang des Verstärkers 4.5 ein taktsynchroner Signalanteil, der sofort wieder zu "0" ausgeregelt wird. Dazu verändert sich der Regelwert 4.16 entsprechend.

Die Spannung an der Sensorelektrode 5.2 wird somit immer gleich der Spannung an C2 gehalten. Eine Vergrößerung der Kapazität an der Sensorelektrode bewirkt somit keine Änderung des Spannungswertes an der Sensorelektrode, sondern führt zu einer Erhöhung der Spannung und somit des elektrischen Feldes 5.4 der umgebenden Elektrode 5.3.

Der dadurch entstehende Vorteil ist in Fig. 7 dargestellt.

Zum Vergleich zeigt Fig. 6 die Kapazitätskurve 6.1 eines Sensors nach dem Stand der Technik. Bei Verkippen oder leichten Entfernen von der Wand entsteht sofort eine starke Kapazitätsänderung. Wird ein solcher Sensor über eine Wand mit Unregelmäßigkeiten geführt, entsteht der anfänglich in Fig. 2 beschriebene Fehler.

Fig. 7 zeigt dagegen die Kapazitätsänderung, wie sie bei gleichem Verkippen oder leichten Entfernen des Sensors von der Wand nach der erfindungsgemäßen Methode entsteht. Abstandsänderungen im Nahbereich der Wand führen zu fast keiner Veränderung der Kapazität und somit auch des Regelwertes. Kapazitätsänderungen in weiter vom Sensor entfernten Bereichen werden jedoch einwandfrei detektiert.

Wird, wie in Fig. 3 gezeigt, ein solcher Sensor über die Wand 1.1 geführt, so haben Unregelmäßigkeiten 2.1 sowie Inhomogenitäten 2.2 keinen Einfluss auf den Kapazitätswert C und somit auf den Regelwert 4.16. Die Ortung des hinter der Wand liegenden Balkens 1.2 erfolgt einwandfrei (Fig. 3, 3.2).

Messungen in der Praxis haben ergeben, das bei einem erfindungsgemäßen Sensor mit einer Fläche von 40 mm Durchmesser auf einer 18 mm starken Spanplatte eine Verkippung von 4-5 mm oder ein Abheben von 2 mm keinen wesentlichen Einfluss auf das Messergebnis hat. Dabei war es gleich, ob sich ein Balken hinter der Spanplatte befand oder nicht.

Im Ausführungsbeispiel der Fig. 4 dienen die hochohmigen Widerstände R3 und R4 zur hochohmigen Abnahme des Spannungssignals an der Sensorelektrode 5.2. Werden ihre Werte gleich groß den Werten von R1 bzw. R2 gewählt, reduziert sich das zu detektierende Signal entsprechend.

Zur Erhöhung der Empfindlichkeit des Sensors kann gemäß Fig. 4.1 das Signal der Sensorelektrode 5.2 bzw. des Kondensators C2 direkt über entsprechende Impedanzwandler 4.21 abgenommen und mit einem nachfolgenden Differenzverstärker 4.23 weiterverarbeitet werden. In diesem Fall sind die Signale der Spannungsquellen 4.9 und 4.10 im Gleichtakt. Die Widerstände R9 und R10 werden dann vorzugsweise gleich groß dem Eingangswiderstand der Eingangsimpedanz der Impedanzwandler 4.21 gewählt oder können bei entsprechend hochohmigen Eingangsimpedanzen von 4.21 entfallen. Die Sendetakte 4.12 und 4.13 weisen dabei keine Phasenverschiebung auf.

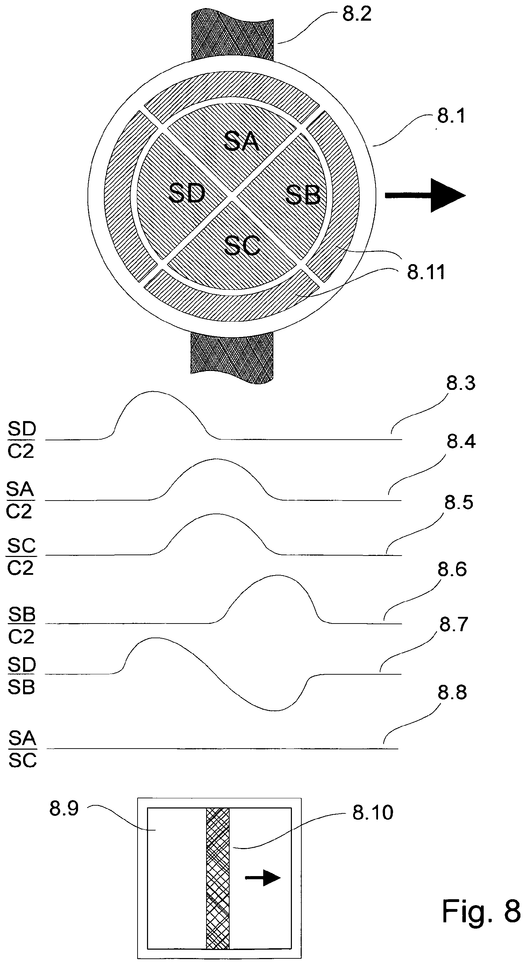

Eine weitere Ausführung eines erfindungsgemäßen Sensors 8.1 zeigt Fig. 8.
Die Sensorfläche 5.2 wurde in vier Sensorteilbereiche, also SA, SB, SC und SD aufgeteilt. Jeder Sensorteilbereich wird entsprechend Fig.5 jeweils von dem entsprechenden umgebenden Elektrodenteilbereich 8.11 umfasst. Ergänzend oder alternativ können auch die Sensorteilbereiche ihrerseits jeweils vollständig oder abschnittsweise von jeweils einer entsprechenden Elektrode umgeben sein. Eine Messung kann nun in der Weise erfolgen, dass jeweils ein Elektrodenteilbereich gegen die Referenzkapazität C2 gemessen wird. Z.B. SD gegen C2 usw. Zusätzlich kann auch jeder der Sensorteilbereiche gegenüber einem anderen Teilbereich gemessen werden, z.B. zur Entscheidung, ob es sich um einen länglichen Balken oder ein kleines Einzelobjekt hinter dem Sensor handelt. Im Ausführungsbeispiel in Fig. 8 werden die Messverläufe des Sensorteilbereichs SD gegen SB und SA gegen SC dargestellt.

In Fig. 8 wird unter dem Sensor 8.1 ein Balken 8.2 von links nach rechts durchgeführt. Die Messungen der Sensorteilbereiche SA bis SD gegenüber der Referenzkapazität C2 ergeben die Messwertverläufe 8.3, 8.4, 8.5 und 8.6. Schon alleine aus diesen Messwertverläufen läst sich die Lage des Balkens berechnen und auf einem Display 8.9 als Balken 8.10 darstellen.

Zusätzliche Informationen liefert das Verhältnis der Kapazitäten der Sensorteilbereiche zueinander. Im Ausführungsbeispiel wird im Messwertverlauf 8.7 das Kapazitätsverhältnis des Sensorteilbereiches SD gegen den Sensorteilbereich SB und im Messwertverlauf 8.8 das Kapazitätsverhältnis des Sensorteilbereiches SA gegen den Sensorteilbereich SC dargestellt. Der Messwertverlauf 8.8 enthält z.B. keine Information, da der Balken bei seiner Bewegung die Sensorteilbereiche SA und SC gleich beeinflusst. So kann die genaue Lage des Balkens errechnet und entsprechend im Display dargestellt werden. Aus der Größe der Messwertänderungen im Messwertverlauf kann zusätzlich auf die Breite des Balkens geschlossen und dies entsprechend im Display dargestellt werden.

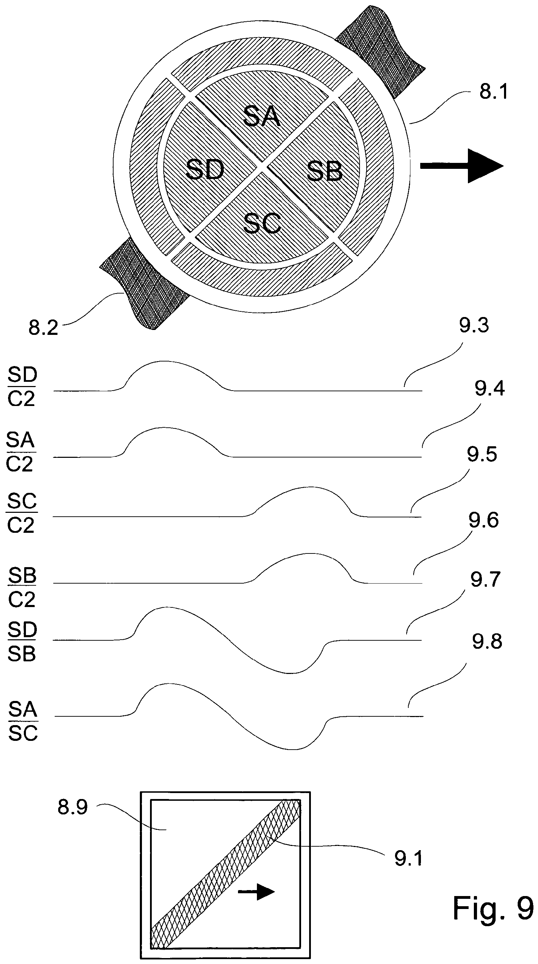

Fig. 9. zeigt die Messwertverläufe 9.3 bis 9.8 und die dazu entsprechende diagonale Darstellung des Balkens 9.1 auf dem Display 8.9 bei diagonaler Bewegung hinter dem Sensor 8.1.

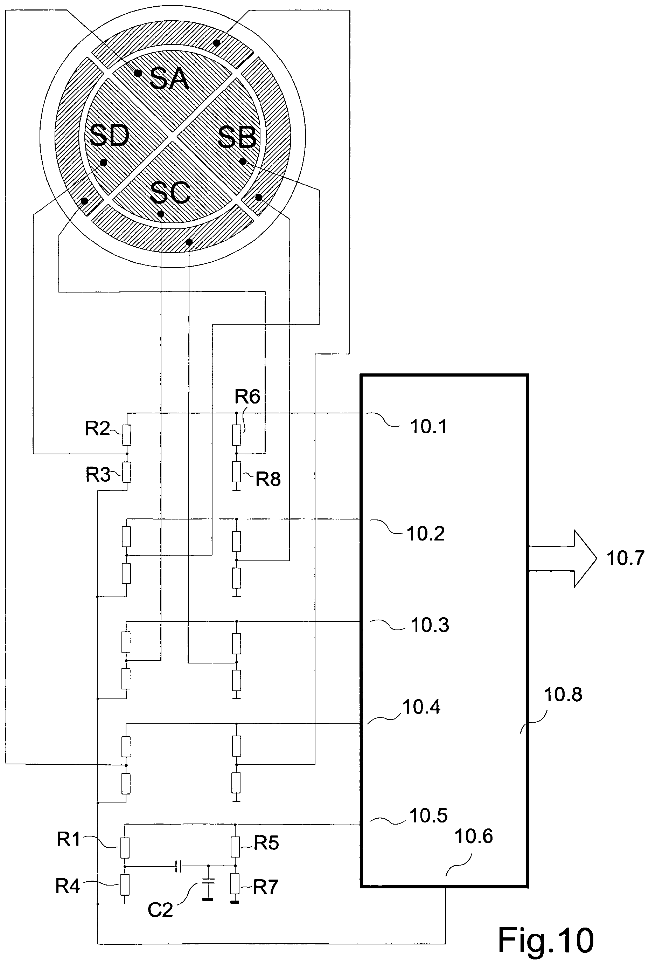

Eine Möglichkeit für die Ausführung einer Elektronik 10.8 für die oben beschriebene Erfindung bietet der IC 909.05 der Fa. Elmos. Die prinzipielle äußere Beschaltung zur Realisierung der Erfindung zeigt Fig. 10. Der IC beinhaltet fünf frei konfigurierbare geregelte Stromquellen 10.1 bis 10.5, (entsprechend den geregelten Spannungsquellen 4.9, 4.10) einen Eingang 10.6, die digitale Ausführung der in der Erfindung beschriebene Signalverarbeitung, eine interne Datenverarbeitungsmöglichkeit und einen entsprechenden Datentransfer 10.7.

In Fig. 10 wird am Beispiel der Beschaltung der geregelten Stromquelle 10.1 dargestellt, wie die in der oben beschriebenen Erfindung eingesetzten Widerstände für die eine Sensorelektrode bzw. umgebende Elektrode beschaltet werden können, ebenso die Beschaltung für eine Referenzkapazität C2.

### Bezugszeichenliste

- 1.1: Wand
- 1.2: Balken
- 1.3: Sensor (Stand der Technik)
- 1.4: Messwert
- 1.6: Schwellwert
- 1.7: Abnahme der Messkurve
- 1.8: Messwerterhöhung
- 1.9: Ruhezustand des Regelwertes
- 2.1: Unregelmäßigkeit
- 2.2: Inhomogenität
- 2.3: Messwert bei Verkippen ohne Balken
- 2.5: Putzbeschichtung
- 2.6: Messwert bei Verkippen mit Balken
- 1.8: Messwerterhöhung
- 4.5: Wechselspannungsverstärker
- 4.6: Synchrondemodulator
- 4.7: integrierender Komparator
- 4.8: Taktgenerator
- 4.9: zweite geregelte Spannungsquelle
- 4.10: erste geregelte Spannungsquelle
- 4.11: Invertierstufe
- 4.12: zweites, invertiertes Taktsignal
- 4.13: erstes Taktsignal
- 4.15: erstes Eingangssignal, Eingangsspannung des Komparator
- 4.16: Regelwert
- 4.17: zweites Eingangssignal, Eingangsspannung des Komparator
- 4.18: Demodulator-Taktsignal
- 4.21: Impedanzwandler
- 4.23: Differenzverstärker
- 5.1: Erfindungsgemäßer Sensor
- 5.11: Sensor mit einer Elektrode
- 5.12: Sensorelektrode im Stand der Technik
- 5.15: Elektromagnetisches Feld
- 5.2: Sensorelektrode
- 5.3: Umgebende Elektrode
- 5.4: Elektrisches Feld der umgebenden Elektrode
- 6.1: Kapazitätskurve (Stand der Technik)
- 8.1: weitere Ausführung des erfindungsgemäßen Sensors
- 8.2: Balken
- 8.3 - 8.8: Messwertverlauf
- 8.9: Display
- 8.10: vertikale Balkendarstellung
- 8.11: umgebende Elektrode
- 9.1: diagonale Balkendarstellung
- 9.3 - 9.8: Messwertverlauf
- 10.1 - 10.5: erste bis fünfte geregelte Stromquelle
- 10.6: Eingang
- 10.8: Elektronik
- D: Distanz
- C2: Referenzkapazität
- SA: Sensorteilbereich A
- SB: Sensorteilbereich B
- SC: Sensorteilbereich C
- SD: Sensorteilbereich D

## Patentansprüche

1. Vorrichtung zur kapazitiven Erfassung eines hinter einem für eine elektromagnetische Strahlung durchlässigen flächigen Gegenstand oder einer Wand (1.1) angeordneten Objekts wie eines Pfosten (1.2), einer Leitung oder eines Fingers mit
- einem Sensor (5.1, 8.1), der Sensorelektroden zur Detektion des Objekts, vorzugsweise zur Detektion von Relativbewegungen zwischen Sensor und flächigem Gegenstand oder Finger aufweist,
- einer Steuerschaltung zur Ansteuerung der Sensorelektroden und zur Auswertung der Ausgangssignale des Sensors,
- wobei der Sensor wenigstens eine Sensorelektrode (5.2; SA, SB, SC, SD) aufweist, die von wenigstens einer weiteren Elektrode (5.3; 8.11) umgeben ist,
**dadurch gekennzeichnet, dass** die Steuerschaltung eine geschlossene Regelung zur konstanten Erhaltung der Signalamplitude an der Sensorelektrode mit wenigstens einer geregelten und von einem Regelwert (4.16) angesteuerten Spannungsquelle (4.9, 4.10) umfasst,
dass die umgebende weitere Elektrode (5.3; 8.11) über die Steuerschaltung mit der Sensorelektrode mittels Invertierstufe (4.11) verbunden ist und
dass die Spannungsquellen (4.9, 4.10) zur gegenläufigen Regelung der Sensorelektrode (5.2; SA, SB, SC, SD) und der umgebenden weiteren Elektrode (5.3; 8.11) vorgesehen sind, wobei bei einer Änderung des Potentials der wenigstens einen Sensorelektrode das Potential der wenigstens einen Sensorelektrode auf ein vorbestimmtes oder vorbestimmbares Potential geregelt wird, indem die umgebende weitere Elektrode in ihrem Potential zur Sensorelektrode gegenläufig geregelt wird.

2. Vorrichtung nach Anspruch 1, **dadurch gekennzeichnet, dass** die Sensorelektrode mehrere Sensorteilbereiche (SA, SB, SC, SD) aufweist, die insgesamt oder jeweils von der wenigstens einen umgebenden Elektrode (8.11) umgeben sind, und dass eine Auswerteeinheit vorgesehen ist, die die Kapazitätsverhältnisse der Sensorteilbereiche und/oder der umgebenden Elektrode zueinander oder zu einer Referenzkapazität (C2) zur Bestimmung der Lage und/oder Dicke des Objekts oder von Inhomogenitäten wie z.B. einer Schraube auswertet.

3. Vorrichtung nach Anspruch 1 oder 2, **dadurch gekennzeichnet, dass** die aktiv auf die Oberfläche des Objektes einwirkende Fläche der umgebenden Elektrode (5.3) etwa gleich groß der Fläche der Sensorelektrode (5.2) ist.

4. Vorrichtung nach einem der vorhergehenden Ansprüche, **dadurch gekennzeichnet, dass** die Steuerschaltung eine Taktsteuerung (4.8) aufweist, die ein Taktsignal an die umgebende Elektrode (5.3; 8.11) zur Regelung des Potentials der Sensorelektrode (5.2) leitet und ein invertiertes Taktsignal als elektrisches Signal einer Referenzkapazität (C1, C2) zuleitet, wobei das von der Sensorelektrode (5.2) empfangene Signal durch äußere Einflüsse beeinflusst ist und mit dem invertierten Taktsignal überlagert ein Eingangssignal bildet, und dass ein Synchrondemodulator (4.6) zur taktweisen Zuordnung des Eingangssignals so vorgesehen ist, dass an den Eingängen eines Komparators (4.7) das taktweise zerlegte Signal zur Bildung eines Vergleichswerts als Regelwert (4.16) ansteht, und dass die wenigstens eine geregelte Spannungsquelle (4.9, 4.10) im Signalgang des Taktsignals und/oder des invertierten Taktsignals vorgesehen ist, die zur Regelung der Amplitudenwerte der Taktsignale den Regelwert (4.16) so verwendet, dass die Amplituden des taktweise zerlegten Eingangssignals zueinander im Wesentlichen gleich groß sind, sodass das Eingangssignal an den Eingängen des Komparators (4.7) im ausgeregelten Zustand keine taktsynchronen Anteile enthält.

5. Vorrichtung nach einem der vorhergehenden Ansprüche, **dadurch gekennzeichnet, dass** die Sensorelektrode (5.2; SA, SB, SC, SD) hochohmig und die umgebende Elektrode (5.3) niederohmig an die Steuerschaltung angekoppelt ist.

6. Verfahren zur kapazitiven Erfassung eines hinter einem für eine elektromagnetische Strahlung durchlässigen flächigen Gegenstand oder einer Wand (1.1) angeordneten Objekts wie einem Pfosten (1.2), einer Leitung oder eines Fingers, wobei eine Relativbewegung zwischen einem mit Elektroden versehener Sensor (5.1; 8.1) und einem flächigen Gegenstand oder dem Objekt erfolgt und durch die Erfassung von Kapazitätsänderungen die Lage des Objekts bestimmt wird und wobei eine Steuerschaltung die Sensorelektroden des Sensors ansteuert und dessen Ausgangssignal auswertet, **dadurch gekennzeichnet, dass** bei einer Änderung des Potentials der wenigstens einen Sensorelektrode (5.2; SA, SB, SC, AD) das Potential der wenigstens einen Sensorelektrode mit einer geschlossenen Regelung zur konstanten Erhaltung der Signalamplitude an der Sensorelektrode mit wenigstens einer geregelten und von einem Regelwert (4.16) angesteuerten Spannungsquelle (4.9, 4.10) auf ein vorbestimmtes oder vorbestimmbares Potential geregelt wird, indem wenigstens eine die Sensorelektrode umgebende weitere Elektrode (5.3; 8.11), welche über die Steuerschaltung mit der Sensorelektrode mittels Invertierstufe (4.11) verbunden ist, in ihrem Potential gegenläufig zur Sensorelektrode geregelt wird.

7. Verfahren nach Anspruch 6, **dadurch gekennzeichnet, dass** die Kapazitätsverhältnisse mehrerer Sensorteilbereiche (SA, SB, SC, SD) des Sensors (8.1) und/oder wenigstens einer die Sensorteilbereiche insgesamt oder jeweils einzeln umgebenden Elektrode (8.11) zueinander oder zu einer Referenzkapazität (C2) zur Bestimmung der Lage und/oder Dicke des Objekts oder von Inhomogenitäten wie z.B. einer Schraube ausgewertet werden.

8. Verfahren nach Anspruch 6 oder 7, **dadurch gekennzeichnet, dass** eine hochohmige Abnahme des Signals des Sensor über eine aktive Schaltung, insbesondere über Impedanzwandler (4.21) erfolgt und dass nach der aktiven Schaltung eine Zusammenführung des Signals der Sensorelektrode (5,2; SA, SB, SC, SD) und eines Referenzsignals aus einer Referenzstrecke aktiv über einen Differenzverstärker (4.23) erfolgt.

9. Verfahren nach einem der Ansprüche 6 bis 8, **dadurch gekennzeichnet, dass** eine Taktsteuerung (4.8) ein Taktsignal an die umgebende Elektrode (5.3) zur Regelung des Potentials der Sensorelektrode leitet und ein invertiertes Taktsignal an wenigstens einer Referenzkapazität (C1, C2) leitet und mit dem von der Sensorelektrode (5.1, 8.11) empfangenen Signal überlagert.

10. Verfahren nach Anspruch 9, **dadurch gekennzeichnet, dass** die Taktsteuerung (4.8) der umgebenden Elektrode (5.3) das Taktsignal zuleitet, das gleichphasig von der Sensorelektrode (5.2) empfangen wird, wobei das an der Sensorelektrode anliegende Signal durch äußere Einflüsse beeinflussbar ist und mit dem invertierten Taktsignal überlagert ein Eingangssignal bildet, und
dass das Eingangssignal taktweise so zergliedert wird, dass an den Eingängen eines Komparators (4.7) das taktweise zerlegte Signal zur Bildung eines Vergleichswerts als Regelwert (4.16) ansteht, und
dass die wenigstens eine geregelte Spannungsquelle (4.9, 4.10) im Signalgang des Taktsignals und/oder des invertierten Taktsignals vorgesehen ist, die zur Regelung der Amplitudenwerte der Taktsignale den Regelwert (4.16) so verwendet, dass die Amplituden des taktweise zerlegten Eingangssignals zueinander im Wesentlichen gleich groß sind, sodass das Eingangssignal an den Eingängen des Komparators (4.7) keine taktsynchronen Anteile enthält.

11. Verfahren nach einem der Ansprüche 6 bis 10, **dadurch gekennzeichnet, dass** die Steuerschaltung mit hoch verstärkenden Bauelementen (4.5, 4.7, 4.23) den Abstand eines Objekts zum Sensor der Amplitude der Messkurven entnimmt.

12. Verfahren nach einem der Ansprüche 6 bis 11, **dadurch gekennzeichnet, dass** die Sensorelektrode (5.2; SA, SB, SC, SD) hochohmig und die umgebende Elektrode (5.3) niederohmig an die Steuerschaltung angekoppelt ist.

## Claims

1. A device for the capacitive detection of an object such as a post (1.2), a line or a finger which is arranged behind a flat article or a wall (1.1), the article or the wall being transparent to electromagnetic radiation, comprising
- a sensor (5.1, 8.1) which comprises sensor electrodes for the detection of the object, preferably for the detection of relative movements between sensor and flat article or finger,
- a control circuit for controlling the sensor electrodes and for evaluating the output signals of the sensor,
- wherein the sensor comprises at least one sensor electrode (5.2; SA, SB, SC, SD) which is surrounded by at least one further electrode (5.3; 8.11),
**characterised in that** the control circuit comprises a closed-loop control for constantly maintaining the signal amplitude at the sensor electrode with at least one regulated voltage source (4.9, 4.10) controlled by a regulating value (4.16), **in that** the surrounding further electrode (5.3; 8.11) is connected via the control circuit to the sensor electrode by means of an inverting stage (4.11), and
**in that** the voltage sources (4.9, 4.10) are provided for an opposed acting control of the sensor electrode (5.2; SA, SB, SC, SD) and the surrounding further electrode (5.3; 8.11), the potential of the at least one sensor electrode being controlled to a predetermined or predeterminable potential in the event of a change in the potential of the at least one sensor electrode, by controlling the potential of the surrounding further electrode in the opposite direction to the sensor electrode.

2. A device according to Claim 1, **characterized in that** the sensor electrode comprises a plurality of sensor sub-portions (SA, SB, SC, SD) which are surrounded as a whole or individually by the at least one surrounding further electrode (8.11), and **in that** there is provided an evaluating unit which evaluates the capacitance ratios of the sub-portions of the sensor and/or of the surrounding further electrode relative to each other or to a reference capacitance (C2) for the purposes of determining the location and/or the thickness of the object or of inhomogeneities such as a screw for example.

3. A device according to Claim 1 or 2, **characterized in that** the surface area of the surrounding further electrode (5.3) which is actively effective on the surface of the object is of about the same size as the surface area of the sensor electrode (5.2)

4. A device according to one of the preceding Claims, **characterized in that** the control circuit comprises a clock pulse generator (4.8) which delivers a clock pulse signal to the surrounding further electrode (5.3; 8.11) for regulating the potential of the sensor electrode (5.2) and supplies an electrical signal in the form of an inverted clock pulse signal to a reference capacitance (C1, C2), wherein the signal received from the sensor electrode (5.2) is affected by external influences and forms an input signal having the inverted clock pulse superimposed thereon, and
**in that** a synchronous demodulator (4.6) for the allocation of the input signal in a clocked manner is provided in such a way that the cyclically sub-divided signal is present at the inputs of a comparator (4.7) for forming a comparative value serving as a control value (4.16), and
**in that** the at least one voltage source (4.9, 4.10) is provided in the signal path of the clock pulse signal and/or the inverted clock pulse signal, said voltage source utilising the control value (4.16) for regulating the amplitude values of the clock pulse signals in such a way that the amplitudes of the cyclically sub-divided input signal are of substantially the same magnitude as one another so that the input signal at the inputs of the comparator (4.7) does not contain clock synchronous components in the stabilised state.

5. A device according to one of the preceding Claims, **characterized in that** the sensor electrode (5.2; SA, SB, SC, SD) is coupled to the control circuit with high impedance and the surrounding electrode (5.3) with low impedance.

6. A method for the capacitive detection of an object such as a post (1.2), a line or a finger which is arranged behind a flat article or a wall (1.1), the flat article or the wall being transparent to electromagnetic radiation, wherein there is a relative movement between a sensor (5.1; 8.1) provided with electrodes and a flat article or the object and the location of the object is determined by detecting changes of capacitance and wherein a control circuit controls the sensor electrodes of the sensor and evaluates the output signal thereof,
**characterised in that**, in the event of a change in the potential of the at least one sensor electrode (5.2; SA, SB, SC, AD), the potential of the at least one sensor electrode is changed with a closed-loop control for constant maintenance of the signal amplitude at the sensor electrode with at least one regulated voltage source (4.9, 4.10) controlled by a regulating value (4.16) to a predetermined or predeterminable potential, wherein at least one surrounding further electrode (5.3; 8.11) surrounding the sensor electrode, which further electrode is connected via the control circuit to the sensor electrode by means of an inverting stage (4.11), is regulated in its potential in a manner opposed to the sensor electrode.

7. A method according to Claim 6, **characterized in that** the capacitance ratios of a plurality of sensor sub-portions (SA, SB, SC, SD) of the sensor (8.1) and/or of the at least one surrounding further electrode (8.11) surrounding the sub-portions of the sensor either as a whole or individually relative to each other or to a reference capacitance (C2) are evaluated for the purposes of determining the location and/or the thickness of the object or of inhomogeneities such as a screw for example.

8. A method according to Claim 6 or 7, **characterized in that** the signal from the sensor is tapped off in high impedance manner by an active circuit and in particular by means of impedance converters (4.21) and **in that**, following the active circuit, a process of combining the signal from the sensor electrode (5.2; SA, SB, SC, SD) with a reference signal from a reference path is effected actively by a differential amplifier (4.23).

9. A method according to one of the Claims 6 to 8, **characterized in that** a clock pulse generator (4.8) supplies a clock pulse signal to the surrounding further electrode (5.3) for regulating the potential of the sensor electrode and supplies an inverted clock pulse signal to at least one reference capacitance (C1, C2) and superimposes thereon the signal received from the sensor electrode (5.1, 8.11).

10. A method according to Claim 9, **characterized in that** the clock pulse generator (4.8) supplies the clock pulse signal to the surrounding further electrode (5.3), said clock pulse signal being received in like phase by the sensor electrode (5.2), wherein the signal on the sensor electrode can be affected by outside influences and, together with the superimposed inverted clock pulse signal, forms an input signal, and
**in that** the input signal is sub-divided in a clocked manner in such a way that the resultant clockwise cyclically sub-divided signal appears at the inputs of a comparator (4.7) for forming a comparative value serving as a control value (4.16), and
**in that** at least one voltage source (4.9, 4.10) is provided in the signal path of the clock pulse and/or the inverted clock pulse, said voltage source utilising the control value (4.16) for regulating the amplitude values of the clock pulse signals in such a way that the amplitudes of the clockwise cyclically sub-divided input signal are of substantially the same size as each other so that the input signal at the inputs of the comparator (4.7) does not contain clock synchronous components.

11. A method according to one of the Claims 6 to 10, **characterized in that** the control circuit derives the spacing of an object relative to the sensor from the amplitude of the measured value curves using high amplification factor components (4.5, 4.7, 4.23).

12. A method according to one of the Claims 6 to 11, **characterised in that** the sensor electrode (5.2; SA, SB, SC, SD) is coupled to the control circuit with high resistance and the surrounding electrode (5.3) with low resistance.

## Revendications

1. Dispositif pour l'acquisition capacitive d'un objet disposé derrière un corps plan ou une paroi (1.1) transparent(e) à un rayonnement électromagnétique, tel qu'un poteau (1.2), un conducteur ou un doigt, comportant
- un détecteur (5.1, 8.1), lequel présente des électrodes de détection pour la détection de l'objet, de préférence pour la détection des déplacements relatifs entre le détecteur et le corps plan ou le doigt,
- un circuit de commande pour commander les électrodes de détection et pour l'exploitation des signaux de sortie du détecteur,
- le détecteur présentant au moins une électrode de détection (5.2, SA, SB, SC, SD), laquelle est entourée par au moins une autre électrode (5.3, 8.11),
**caractérisé en ce que** le circuit de commande comprend un réglage fermé pour maintenir constante l'amplitude des signaux au niveau de l'électrode de détection avec au moins une source de tension (4.9, 4.10) réglée et commandée par une valeur de réglage (4.16),
**en ce que** l'autre électrode entourante (5.3, 8.11) est reliée par le circuit de commande à l'électrode de détection par l'intermédiaire d'une étape d'inversion (4.11) et
**en ce que** les sources de tension (4.9, 4.10) sont prévues pour le réglage opposé de l'électrode de détection (5.2, SA, SB, SC, SD) et de l'autre électrode entourante (5.3, 8.11), le potentiel de la ou des électrodes de détection étant réglé à un potentiel prédéterminé ou pré-déterminable en cas de variation du potentiel de la ou des électrodes de détection, tandis que l'autre électrode entourante est réglée quant à son potentiel, de manière opposée à l'électrode de détection.

2. Dispositif selon la revendication 1, **caractérisé en ce que** l'électrode de détection présente plusieurs zone partielles de détection (SA, SB, SC, SD), lesquelles sont globalement ou individuellement entourées par la ou les électrode(s) entourante(s) (8.11), et **en ce qu'**est prévue une unité d'exploitation qui exploite les rapports de capacité des zones partielles de détection et/ou de l'électrode entourante les uns par rapport aux autres ou par rapport à un condensateur de référence (C2) pour la détermination de l'emplacement et/ou de l'épaisseur de l'objet ou d'inhomogénéités, comme par exemple une vis.

3. Dispositif selon la revendication 1 ou 2, **caractérisé en ce que** la surface de l'électrode entourante (5.3) agissant de manière active sur la surface de l'objet est environ aussi grande que la surface de l'électrode de détection (5.2).

4. Dispositif selon l'une des revendications précédentes, **caractérisé en ce que** le circuit de commande présente une commande d'horloge (4.8), laquelle fournit un signal d'horloge à l'électrode entourante (5.3, 8.11) pour le réglage du potentiel de l'électrode de détection (5.2) et fournit un signal d'horloge inversé en tant que signal électrique à un condensateur de référence (C1, C2), le signal reçu par l'électrode de détection (5.2) étant influencé par des influences extérieures et formant par superposition avec le signal d'horloge inversé un signal d'entrée, et
**en ce qu'**un démodulateur synchrone (4.6) est prévu pour l'association cadencée du signal d'entrée de telle manière qu'au niveau des entrées d'un comparateur (4.7), le signal décomposé de manière cadencée est présent pour la formation d'une valeur de comparaison en tant que valeur de réglage (4.16) et **en ce que** la ou les source(s) de tension (4.9, 4.10) réglée(s) est/sont prévue(s) dans la formation du signal d'horloge et/ou du signal d'horloge inversé et utilise(nt) la valeur de réglage (4.16) pour le réglage des valeurs d'amplitude des signaux d'horloge, de telle sorte que les amplitudes du signal d'entrée décomposé de manière cadencée soient sensiblement égales les unes aux autres, de manière à ce que le signal d'entrée ne contienne pas de composantes synchronisées avec l'horloge aux entrées du comparateur (4.7) à l'état réglé.

5. Dispositif selon l'une des revendications précédentes, **caractérisé en ce que** l'électrode de détection (5.2 ; SA, SB, SC, SD) est couplée au circuit de commande avec une résistance élevée et l'électrode entourante (5.3) avec une résistance basse.

6. Procédé d'acquisition capacitive d'un objet disposé derrière un corps plan ou une paroi (1.1) transparent(e) à un rayonnement électromagnétique, tel qu'un poteau (1.2), un conducteur ou un doigt, dans lequel un déplacement relatif entre un détecteur (5.1 ; 8.1) pourvu d'électrodes et un corps plan ou l'objet se produit et l'emplacement de l'objet est déterminé par l'acquisition des variations de capacité et dans lequel un circuit de commande commande les électrodes de détection du détecteur et exploite leur signal de sortie,
**caractérisé en ce que** le potentiel de la ou des électrodes de détection (5.2 ; SA, SB, SC, SD) est réglé à un potentiel prédéterminé ou pré-déterminable avec un réglage fermé pour maintenir constante l'amplitude de signal au niveau de l'électrode de détection avec au moins une source de tension (4.9, 4.10) réglée et commandée par une valeur de réglage (4.16) en cas de variation du potentiel de la ou des électrodes de détection, tandis qu'au moins une autre électrode (5.3 ; 8.11) entourant l'électrode de détection et qui est reliée au moyen du circuit de commande avec l'électrode de détection par l'intermédiaire d'une étape d'inversion (4.11), est réglée quant à son potentiel de manière opposée à l'électrode de détection.

7. Procédé selon la revendication 6, **caractérisé en ce que** les rapports de capacité de plusieurs zones partielles de détection (SA, SB, SC, SD) du détecteur (8.1) et/ou d'au moins une électrode (8.11) entourant globalement ou individuellement les zones partielles de détection sont exploités les uns par rapport aux autres ou par rapport à un condensateur de référence (C2) pour la détermination de l'emplacement et/ou de l'épaisseur de l'objet ou d'inhomogénéités comme par exemple une vis.

8. Procédé selon la revendication 6 ou 7, **caractérisé en ce qu'**un prélèvement à haute résistance du signal du détecteur est réalisé au moyen d'un circuit actif, en particulier au moyen d'un convertisseur d'impédance (4.21), et **en ce qu'**après le circuit actif, est réalisé activement au moyen d'un amplificateur de différence (4.23), un regroupement du signal de l'électrode de détection (5,2 ; SA, SB, SC, SD) et d'un signal de référence à partir d'un parcours de référence.

9. Procédé selon l'une des revendications 6 à 8, **caractérisé en ce qu'**une commande d'horloge (4.8) fournit un signal d'horloge à l'électrode entourante (5.3) pour le réglage du potentiel de l'électrode de détection et un signal d'horloge inversé à au moins un condensateur de référence (C1, C2) et les superpose avec le signal reçu par l'électrode de détection (5.1, 8.11).

10. Procédé selon la revendication 9, **caractérisé en ce que** la commande d'horloge (4.8) fournit à l'électrode entourante (5.3) le signal d'horloge qui est reçu avec la même phase par l'électrode de détection (5.2), le signal appliqué à l'électrode de détection étant influençable par d'autres influences et formant avec le signal d'horloge inversé par superposition un signal d'entrée, et **en ce que** le signal d'entrée est décomposé de manière cadencée de telle sorte qu'au niveau des entrées d'un comparateur (4.7) le signal décomposé de manière cadencée est présent pour la formation d'une valeur de comparaison en tant que valeur de réglage (4.16) et **en ce qu'**est/sont prévue(s) dans la formation du signal d'horloge et/ou du signal d'horloge inversé la ou les sources de tension (4.9, 4.10) réglée(s) qui utilise(nt) pour le réglage des valeurs d'amplitude des signaux d'horloge la valeur de réglage (4.16) de telle manière que les amplitudes du signal d'entrée décomposé de manière cadencée sont sensiblement égales, de sorte que le signal d'entrée ne contienne pas de composantes synchronisées avec l'horloge aux entrées du comparateur (4.7).

11. Procédé selon l'une des revendications 6 à 10, **caractérisé en ce que** le circuit de commande déduit, avec des composants (4.5, 4.7, 4.23) hautement amplifiés, la distance d'un objet par rapport au détecteur à partir de l'amplitude des courbes de mesure.

12. Procédé selon l'une des revendications 6 à 11, **caractérisé en ce que** l'électrode de détection (5.2 ; SA, SB, SC, SD) est couplée au circuit de commande avec une résistance élevée et l'électrode entourante (5.3) avec une résistance basse.
